(19) Europäisches Patentamt / European Patent Office / Office européen des brevets

(11) **EP 2 728 626 A1**

(12) **EUROPEAN PATENT APPLICATION**
published in accordance with Art. 153(4) EPC

(43) Date of publication:
**07.05.2014 Bulletin 2014/19**

(51) Int Cl.:
***H01L 31/042*** *(2014.01)*

(21) Application number: **12819364.6**

(22) Date of filing: **30.07.2012**

(86) International application number:
**PCT/JP2012/069340**

(87) International publication number:
**WO 2013/018763 (07.02.2013 Gazette 2013/06)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.08.2011 JP 2011168541**

(71) Applicant: **JX Nippon Oil & Energy Corporation Chiyoda-ku Tokyo 100-8162 (JP)**

(72) Inventors:
• **ISHIMARU, Noriyo Chiyoda-ku, Tokyo 100-8162 (JP)**

• **KONDO, Shigeki Chiyoda-ku, Tokyo 100-8162 (JP)**
• **MURATA, Kiyoshi Chiyoda-ku, Tokyo 100-8162 (JP)**
• **FUKUDA, Yasushi Chiyoda-ku, Tokyo 100-8162 (JP)**

(74) Representative: **Style, Kelda Camilla Karen Page White & Farrer Bedford House John Street London, WC1N 2BF (GB)**

(54) **SOLAR CELL MODULE AND METHOD OF MANUFACTURING SAME**

(57) When a tab wire 20 is connected to a busbar electrode 12 on a surface side of a photovoltaic cell 6, the bonding strength at the connection part can be improved and electric resistance can be reduced without reducing the amount of received light. The busbar electrode 12 and the tab wire 20 are bonded via conductive resin 22 having light-transmission property. This conductive resin 22 covers at least a part of a side face of the busbar electrode 12, and preferably reaches the surface of the photovoltaic cell 6. The tab wire 20 may have a width smaller than a width of the busbar electrode 12.

FIG. 7

EP 2 728 626 A1

**Description**

TECHNICAL FIELD

The present invention relates to a photovoltaic module including a plurality of photovoltaic cells and to a method for manufacturing the same.

BACKGROUND ART

A photovoltaic module includes a plurality of photovoltaic cells arranged in a matrix so that adjacent photovoltaic cells are electrically connected in series via a tab wire.
A photovoltaic cell includes, on its surface side, multiple fine linear finger electrodes and at least one (typically two or three) busbar electrode provided to be orthogonal to the finger electrodes. Between adjacent photovoltaic cells, a busbar electrode of one of the photovoltaic cells and an electrode on the rear-surface side of the other photovoltaic cell are connected via a tab wire.
In such a photovoltaic module, a busbar electrode and a tab wire are connected with solder as shown in Patent Documents 1 and 2. In the case of using solder, the solder is applied so as not to protrude from the top face of the busbar electrode, thus avoiding reduction in the amount of light received.

CITATION LIST

PATENT DOCUMENTS

Patent Document 1: Japanese Laid-Open Patent Application Publication No. 2004-204256
Patent Document 2: Japanese Laid-Open Patent Application Publication No. 2005-050780

SUMMARY OF THE INVENTION

PROBLEMS TO BE SOLVED BY THE INVENTION

In order to increase the light-receiving area of a photovoltaic cell to thereby enhance conversion efficiency, a possible method may narrow the line width of busbar electrodes to reduce the light-shielding part by the busbar electrodes.
This structure, however, makes a contact area between a busbar electrode and solder smaller. Such a small contact area increases electric resistance between the busbar electrode and the tab wire, and thus, CTM loss is unfortunately increased.
The CTM (Cell To Module) loss is an index representing a difference between cell efficiency and module efficiency, and is calculated by the following equation.

$$\text{CTM loss} = (1\text{-output ratio A}) \times 100(\%)$$

$$\text{Output ratio A} = [(\text{module output})/(\text{the number of cells})]/[\text{output at the time of cell inspection}]$$

In order to reduce electric resistance between a busbar electrode and a tab wire, a contact area between a busbar electrode and solder, and between a tab wire and solder, or one of them, may be increased. This is because, even when busbar electrodes and tab wires are made thinner, the increased or maintained contact area enables an increase of the light-receiving area without increasing electrical resistance.
Then, the top face and the side face of a busbar electrode may be covered with solder.
In this structure, however, since the part covered with solder does not transmit light at all, light is totally shielded, resulting in a failure to increase the light-receiving area in spite of making busbar electrodes thinner.
Furthermore, the temperature to melt solder is high (about 200 to 300°C), and direct contact of cells with such molten solder may damage the cells.

Since the bonding strength between solder and cell surfaces is very low, an advantageous effect of increasing the bonding strength between solder and cells also cannot be expected.

In view of the above problems, it is an object of the present invention to increase the light-receiving area of a photovoltaic cell, reduce CTM loss by reducing electric resistance at a connection part, improve the bonding strength at the connection part, and the like.

MEANS FOR SOLVING THE PROBLEMS

A photovoltaic module according to the present invention includes a plurality of photovoltaic cells, each photovoltaic cell including a busbar electrode on a surface side. Between adjacent photovoltaic cells, the busbar electrode of one of the photovoltaic cells and an electrode on a rear-surface side of the other photovoltaic cell are connected via a tab wire.

In this photovoltaic module, the busbar electrode and the tab wire are bonded via conductive resin having light-transmission property, and the conductive resin covers at least a part of a side face of the busbar electrode.

A method for manufacturing a photovoltaic module according to the present invention includes the steps of: when the busbar electrode and the tab wire are bonded, placing conductive resin in a tape shape that is wider than the busbar electrode and having light-transmission property on the busbar electrode, and then placing the tab wire; and performing compression-bonding while applying heat thereto, whereby the conductive resin is melted so as to bond with the busbar electrode and the tab wire while covering at least a part of a side face of the busbar electrode.

EFFECT OF THE INVENTION

According to the present invention, conductive resin for bonding is disposed not only at the top face of a busbar electrode but also so as to cover at least a part of a side face of the busbar electrode, and thus, the bonding area with the busbar electrode increases, and the bonding strength can be improved while reducing electric resistance, and CTM loss can be reduced.

Since the conductive resin having light-transmission property is used, even when side faces of the busbar electrode are covered, oblique light can be transmitted, so that the light-receiving amount can be increased or maintained. Additionally, since oblique light can be transmitted, the bonding strength between a tab wire being wider as well and conductive resin can be improved and electric resistance can be reduced.

Since the melting temperature of conductive resin is lower than that of solder, heat load applied to cells can be reduced.

BRIEF DESCRIPTION OF THE DRAWINGS

Fig. 1 is a plan view of a photovoltaic module of an embodiment of the present invention.
Fig. 2 is a cross-sectional view taken along line A-A of Fig. 1.
Fig. 3 is a plan view of a photovoltaic cell.
Fig. 4 is a front view of a photovoltaic cell.
Fig. 5 is a plan view showing a connection state between photovoltaic cells.
Fig. 6 is a front view showing a connection state between photovoltaic cells.
Fig. 7 is a cross-sectional view of a tab wire connection part to a busbar electrode of a first embodiment of the present invention, which corresponds to the cross section taken along line B-B of Fig. 6.
Fig. 8 shows the manufacturing process of the first embodiment.
Fig. 9 is a cross-sectional view of a tab wire connection part to a busbar electrode of a second embodiment of the present invention, which corresponds to the cross section taken along line B-B of Fig. 6.
Fig. 10 shows the manufacturing process of the second embodiment.
Fig. 11 shows modification example 1, combined with a busbar electrode having a modified cross section.
Fig. 12 shows modification example 2, combined with a busbar electrode having a modified cross section.
Fig. 13 shows modification example 3, combined with a busbar electrode having a modified cross section.
Fig. 14 shows modification example 4, combined with a busbar electrode having a modified cross section.

MODE FOR CARRYING OUT THE INVENTION

A detailed description of embodiments of the present invention follow.

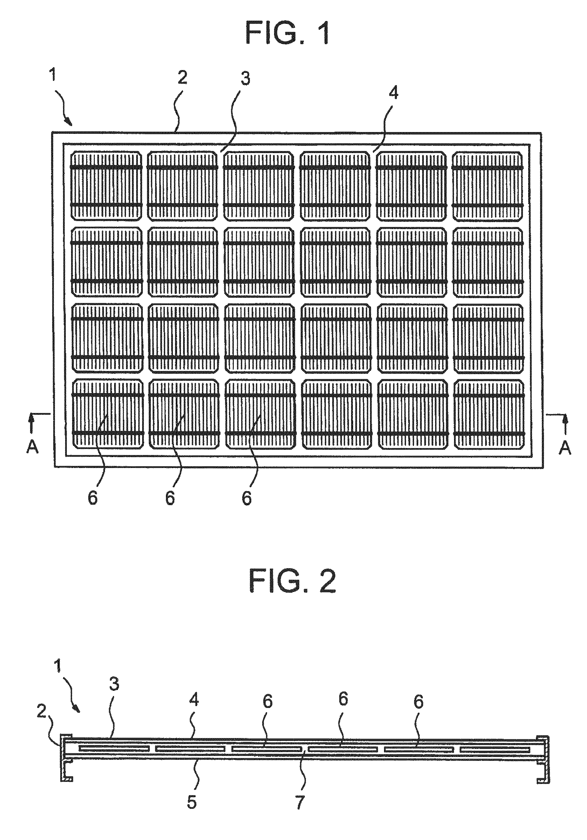

Fig. 1 is a plan view of a photovoltaic module of an embodiment of the present invention, and Fig. 2 is a cross-sectional view taken along line A-A of Fig. 1.

A photovoltaic module 1 includes a rectangular frame 2 made of metal (for example, aluminum) and a PV (photovoltaic) panel 3 fitted into an upper part in the frame 2.

The PV panel 3 includes: a transparent surface-side cover 4 such as tempered white glass; a weather-resistant rear-surface-side cover 5 made of a resin film; a plurality of photovoltaic cells 6 arranged in a matrix shape between the surface-side cover 4 and the rear-surface-side cover 5 and electrically connected in series; and a filling adhesive 7 charged between the surface-side cover 4 and the rear-surface-side cover 5 to form a panel with the covers 4, 5 and the photovoltaic cells 6.

The surface-side cover 4 is required to transmit sunlight, insulate, be weather resistant, be heat resistant, be moisture proof, be resistant to fouling and to photodegradation, and is further required to have excellent chemical strength and toughness as well as be scratch resistant, absorb shocks and the like to achieve long-term service life.

Therefore, a transparent glass substrate is widely used for this purpose, and in particular, tempered white glass of 4.0 mm in thickness is used, which is excellent in light transmission and impact resistance. As a material, soda lime glass is preferably used. The thickness may be 0.1 to 10 mm.

As the surface-side cover 4, of course, a well-known sheet glass may be adopted, and films or sheets made of, for example, polyamide-based resin (various types of nylon), polyester-based resin, cyclic polyolefin-based resin, polystyrene-based resin, fluorine-based resin, polyethylene-based resin, (meth)acrylic-based resin, polycarbonate-based resin, acetal-based resin, cellulose-based resin and other various types of resin, may be adopted.

As the rear-surface-side cover 5, for example, a resin coated metal sheet of about 0.1 mm thickness is preferably adopted, such as an aluminum sheet of which both faces are coated with a polyvinyl fluoride film (fluorine film) having excellent insulation property.

For instance, a film or a sheet made of polyethylene-based resin, polypropylene-based resin, cyclic polyolefin-based resin, polystyrene-based resin such as syndiotactic polystyrene resin, acrylonitrile-styrene copolymer (AS resin), acrylonitrile-butadiene-styrene copolymer (ABS resin), polyvinyl chloride-based resin, fluorine-based resin such as polyvinylidene fluoride, poly(meth)acrylic-based resin, polycarbonate-based resin, polyester-based resin such as polyethylene terephthalate (PET) or polyethylene naphthalate (PEN), polyamide-based resin such as various types of nylon, polyimide-based resin, polybutylene terephthalate resin, polyamide-imide-based resin, polyallyphthalate-based resin, polycyclohexenedimethanol - terephthalate resin, silicon-based resin, polysulfone-based resin, polyphenylene sulfide-based resin, polyethersulfone-based resin, polyurethane-based resin, acetal-based resin, cellulose-based resin, polyester resin containing polyester such as PET-G that is copolymer of PET and PEN, and other various types of resins may be adopted, or a film or a sheet made of ceramics, glass, stainless-steel or the like may be adopted.

These films or sheets may be transparent or a base material, into which white pigment or black pigment is kneaded.

A film made of these resins may undergo corona discharge treatment, ozone treatment, plasma treatment using oxygen gas or nitrogen gas, glow discharge treatment, oxidation treatment using chemical agents and the like to achieve the bonding strength with the filling adhesive.

A base layer may be provided at the surface of the film beforehand so as to achieve bonding strength with the filling adhesive. For instance, any layer including a primer coating agent layer, an undercoating agent layer, an anchor coating agent layer, an adhesive layer or a deposited anchor coating layer may be formed as the base layer.

The photovoltaic cell 6 may be any one of single crystal silicon, thin-film silicon, polycrystalline silicon, amorphous silicon and a compound semiconductor type cell.

As one example, a typical photovoltaic cell 6 made of crystal silicon includes an n-type diffusion layer (n-type silicon layer) formed on the light-incident face (the surface on the light-incident side when electricity is generated) of a p-type crystal silicon substrate. More specifically, the photovoltaic cell is manufactured by the following texture step, p-n junction step, antireflection film formation step and surface and rear-surface collector electrodes formation step.

In the texture formation step, prior to the formation of p-n junction on a substrate, the surface of the substrate is etched using acid or alkaline solution or using reactive plasma, to form an irregular structure (texture structure) on the surface.

In the p-n junction formation step, although the method of forming a p-n junction is not limited particularly, n-type impurities may be diffused on the light-receiving face side of a p-type silicon substrate, to form a p-n junction. The diffusion of n-type impurities may be performed by placing a substrate in high-temperature gas containing a material (for example, POC13) including n-type impurities, for example.

In the antireflection film formation step, an antireflection film is formed on the light-receiving face side of the substrate. For instance, a SiN film may be formed by plasma CVD.

In the surface and rear-surface collector electrodes formation step, as described later, finger electrodes and busbar electrodes are formed on the surface of the photovoltaic cell 6, and a rear-surface electrode is formed on the rear surface thereof.

The filling adhesive 7 is required to be translucent and adhesiveness with the surface-side cover and the rear-surface-side cover. In view of the protection of photovoltaic cells, and it is further required to have light-resistant property, heat-resistant property, water-proof property, scratch-resistant property, shock absorbability and the like. The filling adhesive 7 typically may be a film made of ethylene-vinyl acetate copolymer, such as an EVA (ethylene-vinylacetate) film having excellent moisture-proof property, which contains organic peroxides.

Other exemplary resins include one type of resin including ionomer resin, polyvinylbutyral resin, silicon resin, epoxy-based resin, (meth)acrylic-based resin, fluorine-based resin, ethylene-acrylic acid or methacrylic acid copolymer, polyethylene resin, polypropylene resin, acid-modified polyolefinic-based resin obtained by modifying polyolefin-based resin such as polyethylene or polypropylene with unsaturated carboxylic acid such as acrylic acid, itaconic acid, maleic acid or fumaric acid, or a mixture of two or more types of the abovementioned resins.

In view of light-resistant property, heat-resistant property, water-proof property and the like, ethylene-vinyl acetate-based resin is particularly preferable.

The abovementioned filling adhesive 7 may have a thickness of about 100 to 1,000 $\mu$m, and preferably has a thickness of about 300 to 500 $\mu$m.

The following describes the structure of collector electrodes of the photovoltaic cell 6.

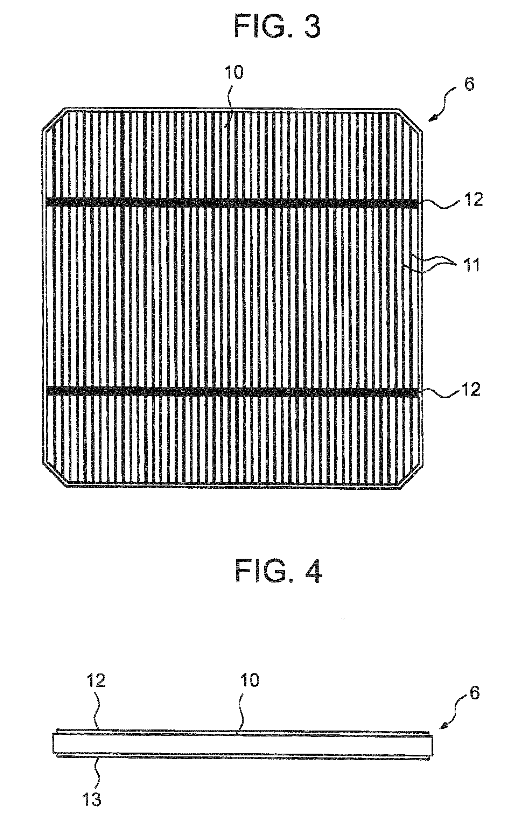

Fig. 3 is a plan view of a photovoltaic cell, and Fig. 4 is a front view of a photovoltaic cell.

The surface side of the photovoltaic cell 6 is a light-receiving face 10, on which a plurality of finger electrodes 11 are disposed. The finger electrodes 11 are thin enough to minimize the inference with light incident thereon, and the finger electrodes 11 extend in a predetermined direction and are arranged in parallel at predetermined intervals in the direction orthogonal to the extending direction.

On the surface (the light-receiving face 10) side of the photovoltaic cell 6, relatively thick busbar electrodes 12 are disposed so as to be orthogonal to the finger electrodes 11 on the finger electrodes 11 to obtain electric power. Thus, the busbar electrodes 12 extend in the parallel-arranged direction of the finger electrodes 11 so as to connect the plurality of finger electrodes 11. About ninety finger electrodes 11 with a width of about 0.05 mm, for example, are arranged, and at least one busbar electrode 12 (one to four, typically two or three busbar electrodes 12) with a width of about 0.5 to 3 mm, for example, are arranged.

On the rear-surface side of the photovoltaic cell 6, a rear-surface electrode 13 is provided entirely. Although not illustrated, busbar electrodes are provided on the rear-surface electrode 13 as well to connect tab wires.

Collector electrodes may be made of well-known materials capable of establishing electric conduction, and example materials include metal such as Ag, Ni, Cu, Sn, Au, V, Al, or Pt, or alloy or mixture of two or more metals of the foregoing. Alternatively, the lamination of a plurality of these metals may be used. Still alternatively, a carbon material, a single transparent conductive material (ITO) or a composite of these materials and the above metals may be used. It is important to use such a material that does not have resistance when current generated at the photovoltaic cells flows (about 5 to 10 $\Omega$cm$^{-1}$).

The collector electrodes may be typically formed by the method of printing conductive paste. Exemplary conductive paste includes typical glass paste containing silver, silver paste, gold paste, carbon paste, nickel paste or aluminum paste including adhesive resin in which various types of conductive particles are dispersed, as well as ITO formed by baking or evaporation, for example. Among them, in view of heat-resistant property, conductivity, stability and cost, glass paste containing silver is preferably used. Other exemplary methods include sputtering using a mask pattern, resistance heating, CVD, photo-CVD and plating.

A method for forming the finger electrodes 11 and the busbar electrodes 12 is not limited particularly, and typically these electrodes may be formed by applying glass paste containing silver by screen printing, followed by drying and baking.

A method for forming the rear-surface electrode 13 is not limited particularly, and may be formed by applying aluminum paste, followed by drying and baking, for example. The drying and baking on the surface side and the drying and baking on the rear-surface side may be performed separately or concurrently.

During the baking to form the surface collector electrodes, conductive paste is allowed to fire-through the antireflection film, to thereby form the surface collector electrodes to be in contact with the n-type diffusion layer. Herein, the fire-through is a phenomenon such that glass frit or the like included in the conductive paste penetrates through the antireflection film as an insulation film to establish electrical continuity between the surface collector electrodes and the n-type diffusion layer.

Next, the following describes an electric connection structure between photovoltaic cells 6 and 6.

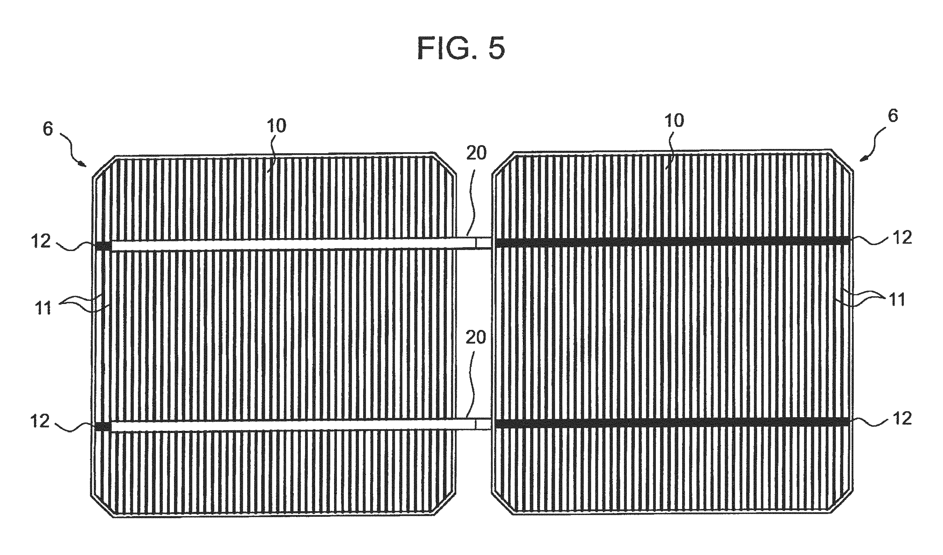

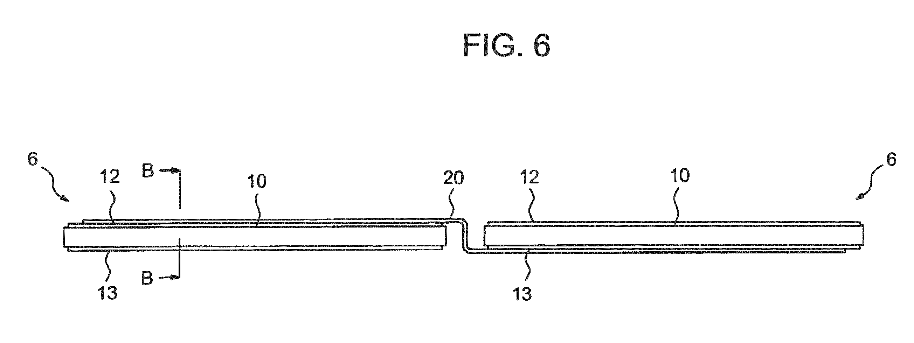

Fig. 5 is a plan view showing a connection state between photovoltaic cells, and Fig. 6 is a front view showing a connection state between photovoltaic cells.

Adjacent photovoltaic cells 6 and 6 are mutually electrically connected in series via a tab wire 20. That is, between the adjacent photovoltaic cells 6 and 6, a busbar electrode 12 on the surface side of one of the photovoltaic cells 6 and a rear-surface electrode 13 on the rear-surface side of the other photovoltaic cell 6 are connected via the tab wire 20. In other words, one end of the tab wire 20 is connected to the busbar electrode 12 on the surface side of the one photovoltaic cell 6 via a conductive bonding medium and the other end of the tab wire 20 is connected to the rear-surface electrode 13 on the rear-surface side of the other photovoltaic cell 6 via a conductive bonding medium. Thus, the tab wire 20 is bent between the photovoltaic cells 6, 6 to connect the surface and the rear surface.

The tab wire 20 is required to secure conductivity, mechanical strength and the like, while having high connection strength with a conductive bonding medium that is used for bonding of the collector electrodes on the cell surface and the tab wire. In view of achieving conductivity between photovoltaic cells more reliably, the tab wire is preferably made of one type or more of metal elements selected from the group consisting of Cu, Ag, Au, Fe, Ni, Pb, Zn, Co, Ti and Mg.

A typical tab wire includes copper foil as a core material and a plating layer on the surface of the core material, which is made of tin of about tens of $\mu$m in thickness. For example, the core material may be a rectangular conductor made of pure copper such as tough pitch copper or oxygen-free copper, and the plating layer on the surface thereof typically may be Sn-Pb eutectic solder. The plating layer on the surface may be Sn-Ag based, Sn-Bi based, Sn-Cu based solder or the like.

In the present embodiment, the aforementioned conductive adhesive medium used for connection of a tab wire 20, in particular, a conductive adhesive medium on the surface side, is conductive resin having light-transmission property.

Such a conductive resin is required to have adhesiveness with collector electrodes on the cell surface and conductivity as well as moisture-proof property and heat-resistant property to maintain reliability.

Exemplary materials used for the conductive resin include polycarbonate, triacetylcellulose, polyethylene terephthalate, polyvinyl alcohol, polyvinyl butyral, polyether imide, polyester, ethylene-vinyl acetate copolymer, polyvinyl chloride, polyimide, polyamide, polyurethane, polyethylene, polypropylene, polystyrene, polyacrylonitrile, butyral resin, acrylonitrile-butadiene-styrene copolymer (ABS resin), ethylene/tetrafluoroethylene copolymer, fluorine resin such as polyvinyl fluoride, epoxy resin, acrylic resin, phenol resin, urethane resin, silicon resin, maleimide resin, bismaleimide resin, triazine-bismaleimide resin and phenol resin, resins such as cyanate resin polyvinyl acetate, rubber, and urethane. At least one type selected from the foregoing or mixture or copolymer of these resins is preferably used. Thermosetting property or UV curable property is preferably given to these resins. Ultraviolet absorbing agent, light stabilizer, oxidation inhibitor or silane coupling agent may be added to the resin properly. In view of being curable at a low temperature in a short time, epoxy resin or acrylic resin is preferable for manufacturing.

The conductive resin may include fine particles. Fine particles included in the resin lead to high conductivity achieved after thermo-compression bonding because the fine particles are brought into contact with each other during the thermo-compression bonding process.

When conductive particles are used as the fine particles, at least one type of metal particles selected from silver, copper, platinum, nickel, gold, tin, aluminum, bismuth, indium, palladium, zinc, cobalt and the like, or alloy or mixture of the foregoing may be used. They may be made of a carbon material or a composite material of carbon particles and metal. They may be at least one type of inorganic oxide selected from alumina, silica, ceramics, titanium oxide, glass or the like, coated with metal, or may be at least one type selected from epoxy resin, acrylic resin, polyimide resin, phenol resin, urethane resin, silicon resin or the like or mixture or copolymer of these resins, coated with metal. The fine particles may be 2 to 30 $\mu$m in diameter, preferably has the average particle size of about 10 $\mu$m.

The conductive resin preferably has high light-transmission property. Specifically, transparent resin having light-transmission property of 80% or more for the overall energy in the wavelength region of 400 to 1,000 nm is preferable.

The following describes a connection structure of the tab wire 20 to the busbar electrode 12 on the surface side of the photovoltaic cell 6.

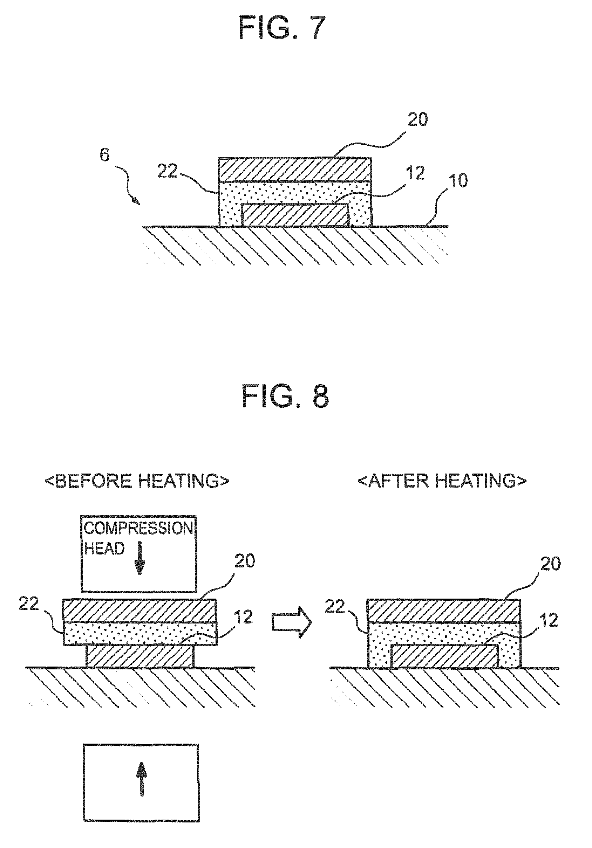

Fig. 7 is a cross-sectional view of a tab wire connection part to a busbar electrode of a first embodiment of the present invention, which corresponds to the cross section taken along line B-B of Fig. 6.

the tab wire 20 is bonded over a busbar electrode 12 on the surface side of the photovoltaic cell 6 via conductive resin 22 having light-transmission property, and the conductive resin 22 is disposed to extend over from the top face of the busbar electrode 12 to both side faces thereof so as to cover both side faces of the busbar electrode 12.

The conductive resin 22 may cover at least a part of the side faces of the busbar electrode 12, and in the present embodiment, the conductive resin 22 covers the entire side faces of the busbar electrode 12 so as to reach the surface of the photovoltaic cell 6.

Fig. 8 shows the manufacturing process of the first embodiment.

On the busbar electrode 12 on the surface side of the photovoltaic cell 6, the conductive resin 22 having light-transmission property that is in a tape shape wider than the busbar electrode 12 is placed, and then the tab wire 20 is placed, against which a compression head heated (about at 140 to 200°C) is pressed. Thereby, the conductive resin 22 is melted so as to bond with the busbar electrode 12 and the tab wire 20 while covering both side faces of the busbar electrode 12.

In the embodiment of the present embodiment, the width of the tab wire 20 is made substantially equal to the width of the tape-shape conductive resin 22 before heating and greater than the width of the busbar electrode 12.

According to the present embodiment, the following advantageous effects can be obtained.

The conductive resin 22 as the conductive bonding medium is provided not only at the top face of the busbar electrode 12 but also so as to cover at least a part of the side faces of the busbar electrode 12, and thus, the bonding area with the busbar electrode 12 increases. Therefore, even if the width of the busbar electrode 12 is narrowed, the bonding strength can be improved and, electric resistance can be reduced and CTM loss can be reduced.

Since the conductive resin 22 used has light-transmission property, even when the side faces of the busbar electrode 12 are covered, oblique light can be transmitted, so that the light-receiving amount can be increased or maintained.

According to the present embodiment, since the width of the tab wire 20 is made greater than the width of the busbar electrode 12, the bonding strength between the tab wire 20 and the conductive resin 22 can be improved. On the other hand, such a wider tab wire 20 may increase a part of the shadow of the tab wire 20. However, when the conductive resin 22 having light-transmission property are used, oblique light can be transmitted, so that a decrease in the light-receiving amount due to a wider tab wire 20 can be suppressed.

According to the present embodiment, the conductive resin 22 covers the side faces of the busbar electrode 12 to reach the surface of the photovoltaic cell 6. Herein, since the conductive resin 22 and the cell surface have good adhesiveness, such a structure also can improve the bonding strength greatly. Additionally, the heating temperature of the conductive resin 22 during bonding is about 140 to 200°C, which is lower than the heating temperature (200 to 300°C) during bonding with solder, and thus, problems hardly occur due to heat load applied to the cell surface.

According to the present embodiment, the tape-shape conductive resin 22 which is wider than the busbar electrode 12 is used. Thus, the width thereof can be easily controlled at the manufacturing process, which leads to the advantageous effects of covering the side faces of the busbar electrode 12 reliably, or facilitating the control of the degree of covering.

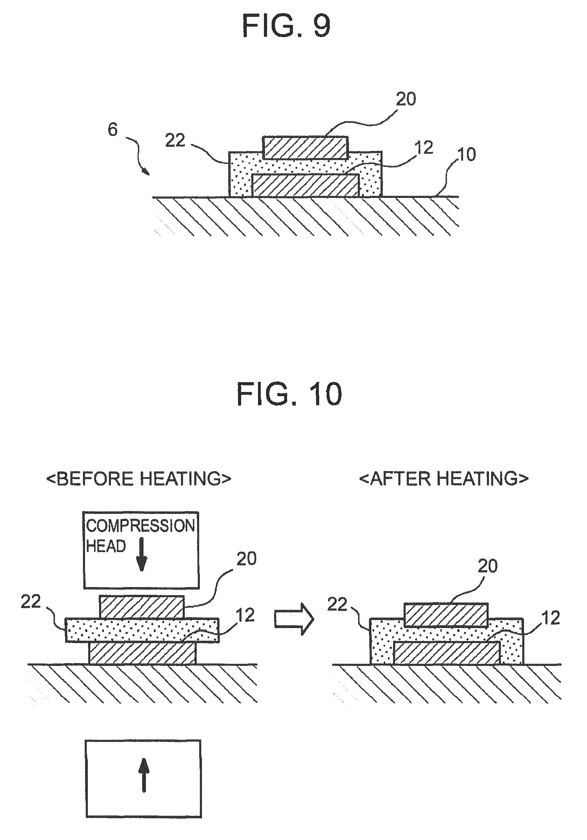

Fig. 9 is a cross-sectional view of a tab wire connection part to a busbar electrode of a second embodiment of the present invention, which corresponds to the cross section taken along line B-B of Fig. 6.

The tab wire 20 is bonded over the busbar electrode 12 on the surface side of the photovoltaic cell 6 via the conductive resin 22 having light-transmission property, and the conductive resin 22 is disposed to extend over from the top face of the busbar electrode 12 to both side faces thereof so as to cover both side faces of the busbar electrode 12.

In the present embodiment, the width of the tab wire 20 is made smaller than the width of the conductive resin 22 and smaller than the width of the busbar electrode 12. Then, a part of the tab wire 20 is embedded in the conductive resin 22 by compression bonding.

Fig. 10 shows the manufacturing process of the second embodiment.

On the busbar electrode 12 on the surface side of the photovoltaic cell 6, the conductive resin 22 having light-transmission property that is in a tape shape wider than the busbar electrode 12 is placed, and then, the tab wire 20 is placed, against which a compression head heated (about at 150°C) is pressed. Thereby, the conductive resin 22 is melted so as to bond with the busbar electrode 12 and the tab wire 20 while covering both side faces of the busbar electrode 12.

In the embodiment of the present embodiment, the width of the tab wire 20 is made smaller than the width of the tape-shape conductive resin 22 before heating and smaller than the width of the busbar electrode 12. Therefore, after compression bonding, a part of the tab wire 20 is embedded in the conductive resin 22.

According to the present embodiment, since the width of the tab wire 20 is smaller than the width of the busbar electrode 12, the shadow is not cast by the tab wire 20 and light is not shielded by the tab wire 20. In other words, the entire part of the cell surface on which the busbar electrode 12 is not disposed, serves as the light-receiving area, and thus, the light-receiving area is determined by the width of the busbar electrode 12, and a decrease of the light-receiving area by the tab wire 20 can be avoided.

Although the width of the tab wire 20 becomes narrow, since the tab wire 20 is embedded in the layer of the conductive resin 22, a certain contact area between the tab wire 20 and the conductive resin 22 can be obtained, and thus, sufficient bonding strength can be obtained and electric resistance can be reduced.

The following describes embodiments implemented by combining the above first or second embodiment. Specifically, the following describes embodiments (modification example) including a busbar electrode 12 having a modified cross section so as to improve the bonding strength. The "modified cross section" means a shape having intentional irregularities or divided parts at its contour unlike a rectangular shape that is a typical cross section for a busbar electrode (this is not a strict rectangular shape but has roundness at the corner due to printing or the like).

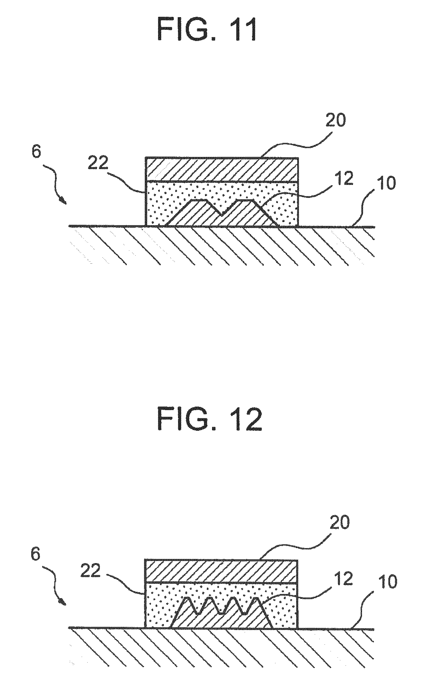

Fig. 11 shows modification example 1, in which irregularities (concave grooves and convex ridges along the extending direction of the electrodes 12) are formed at the top face of the busbar electrode 12, thereby increasing the bonding surface area and improving the bonding strength and conductivity. The irregularities may be in an arc shape or a rectangular shape instead of the triangle shape in the drawing.

Fig. 12 shows modification example 2, where numerous minute irregularities are further formed at the top face of the busbar electrode 12.

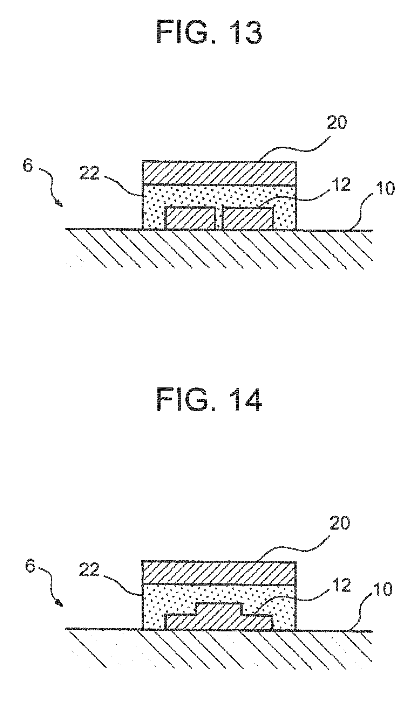

Fig. 13 shows modification example 3, in which the busbar electrode 12 is divided (separated) into a plurality of pieces, thereby increasing the bonding surface area corresponding to the divided parts, and improving the bonding strength and conductivity. The cross-sectional shape of each divided member is not limited to a rectangle as in the drawing, which may be a circle or a triangle.

Fig. 14 shows modification example 4, in which a corner part of a typical rectangular cross section of a busbar electrode 12 is cut so as to increase the number of corner parts. Although the bonding surface area does not increase, the number of corner parts increases to thereby increase the bonding strength.

The modification examples 1 to 4 illustrated in Figs. 11 to 14 are combined with the abovementioned first embodiment, of course, the modification examples 1 to 4 may be combined with the second embodiment (including the width of the tab wire 20 narrower than busbar electrode 12).

The following describes results of the implementation.

The widths of the busbar electrodes were set at four widths of 0.8 mm, 1.0 mm, 1.2 mm and 1.5 mm. The widths of the conductive resin tapes were set at five widths of 0.8 mm, 1.0 mm, 1.2 mm, 1.5 mm and 1.8 mm. The widths of the tab wires were set at four widths of 0.8 mm, 1.0 mm, 1.2 mm and 1.5 mm. Then, they were combined as in the below-described Table 1.

The tab wires were joined to the busbar electrodes via the conductive resin as follows.

A conductive resin tape was placed so as to cover a busbar electrode. Then, a tab wire was overlaid thereon, followed by light compression bonding. Then, the photovoltaic cell was heated while applying pressure from above the tab wire in the direction of the photovoltaic cell.

At this time, a rear-surface busbar electrode was disposed on the rear-surface side at the same position as on the surface side, and similarly to the surface, a conductive resin tape and a tab wire were set, and the same pressure as that to the surface was applied in the opposed direction. Such thermo-compression bonding performed concurrently at the cell surface and rear surface gives the same pressure applied to the cell from the upper and lower directions. Therefore, pressure was not applied in one direction, and thus, the cell was not deformed in one direction for breakage.

The thermosetting treatment can be performed by applying heat at 140 to 200°C and pressure at 0.5 to 20 MPa for 5 to 100 seconds, for example. In this example, a device was used, which was configured to include thermo-compression heads heated at 170°C located above and below the cell, and capable of applying constant pressure from above and below in the vertical direction to the cell, and a photovoltaic cell was set at this device. Then, the photovoltaic cell was sandwiched at the pressure of 5 MPa, and heat was applied for 40 seconds, for example, that is time required for curing the conductive adhesive.

Typically as thermosetting type resin for bonding is heated, the viscosity thereof reduces once, and then cross-linking is accelerated by a curing agent, and the curing is completed. Thermocompression bonding by the aforementioned method makes the conductive resin in a flowing state at a part on the periphery of the busbar electrode, so that the conductive resin is placed so as to be along the shape of the busbar electrode, and then is cured by heat. As a result, the tab wire and the busbar electrode are joined while embedding the busbar electrode in the conductive resin.

Similarly, the second photovoltaic cell was overlaid on the tab wire, followed by light compression bonding, and the bonding was performed in the similar procedure as above, whereby a desired number of photovoltaic cells were coupled for joining. Herein, the cells were thermocompression bonded one by one, or a plurality of cells may be thermocompression bonded concurrently.

The materials used were as follows:

- Photovoltaic cells: 125 mm x 125 mm, thickness 300 $\mu$m;
- Busbar electrode: silver glass paste, length 125 mm;
- Surface-side cover: glass substrate, 30 mm x 30 mm, thickness 3.2 mm;
- Tab wire: Cu wire of predetermined width and 0.15 mm in thickness, both sides of which were dip-plated with Sn-Ag-Cu lead-free solder to be in 20 $\mu$m in thickness;
- Conductive resin tape: tape made of epoxy resin, in which Cu particles were dispersed;
- Filling adhesive: resin sheet for sealing including an ethylene-vinyl acetate copolymer sheet, measuring 30 mm $\times$ 30 mm $\times$ 0.5 mm; and
- Rear-surface side cover: rear-surface protective sheet including a polyethylene terephthalate film (200 $\mu$m in thickness).

A photovoltaic module was manufactured as follows.

After coupling the cells, a glass substrate was placed on a heating stage of a vacuum laminator. On a surface of the glass substrate, a resin sheet for sealing was placed, two sets of two coupled cells were arranged side by side, another resin sheet for sealing was placed, and a rear-surface protective sheet was overlaid thereon.

Vacuum lamination treatment was performed for 5 minutes so that pressure at 0.1 MPa was applied to the lamination while keeping the stage at 150°C, whereby a photovoltaic module was manufactured.

CTM loss was measured as follows.

Output (W) during cell inspection and module output (W) were measured, and output ratio and CTM loss were calculated by the following equations:

$$\text{Output ratio A=[(module output)/(the number of cells)]/[output at the time of cell inspection]}$$

$$\text{CTM loss = (1-output ratio A)} \times 100(\%)$$

The results are as shown in Table 1.

CTM loss of Examples 1 to 4 (the width of a conductive resin tape being greater than the width of a busbar electrode so that the conductive resin covers the busbar electrode) was suppressed at the 6% level.

On the other hand, CTM loss of comparative examples 1 and 2 was at the level of 7%, because the width of the conductive resin tape was smaller than the width of the busbar electrode.

[Table 1]

| Examples | Busbar electrode width | Conductive resin tape width | Tab wire width | CTM loss |
|---|---|---|---|---|
| 1 | 1.2mm | 1.5mm | 1.5mm | 6.9% |
| 2 | 0.8mm | 1.0mm | 1.0mm | 6.7% |
| 3 | 1.5mm | 1.8mm | 1.2mm | 6.4% |
| 4 | 1.0mm | 1.2mm | 1.0mm | 6.0% |
| Comp. Ex. 1 | 1.2mm | 1.0mm | 1.5mm | 7.6% |
| Comp. Ex. 2 | 1.0mm | 0.8mm | 0.8mm | 7.2 % |

With regard to a conventional example (using solder), the measurement was performed.

In this conventional example, solder was applied on a busbar electrode of 1.2 mm in width so as not to protrude from the busbar electrode, on which a tab wire of 1.5 mm in width was placed. Then, heat was applied at 250°C to melt solder, whereby the tab wire and the busbar electrode were joined so as to couple adjacent cells.

After coupling the cells, a glass substrate was placed on a heating stage of a vacuum laminator. On a surface of the glass substrate, a resin sheet for sealing was placed, two sets of two coupled cells were arranged side by side, another resin sheet for sealing was placed, and a rear-surface protective sheet was overlaid thereon.

Then vacuum lamination treatment was performed for 5 minutes so that pressure at 0.1 MPa was applied to the lamination while keeping the stage at 150°C, whereby a photovoltaic module was manufactured.

For such a conventional example, the output during cell inspection and the module output were measured, and CTM loss thereof was calculated. The result was 7.5%.

The embodiments described above simply illustrate the present invention, and needless to say, the present invention includes one directly indicated by the aforementioned embodiments, as well as various improvements and modifications, which is achieved by one skilled in the art within the scope of the appended claims.

REFERENCE SIGNS LIST

1     Photovoltaic module
2     Frame
3     PV panel
4     Surface-side cover
5     Rear-surface-side cover
6     Photovoltaic cell
7     Filling adhesive
10    Light-receiving face
11    Finger electrode
12    Busbar electrode
13    Rear-surface electrode
20    Tab wire

22    Conductive resin having light-transmission property

**Claims**

1. A photovoltaic module comprising a plurality of photovoltaic cells, each photovoltaic cell including a busbar electrode on a surface side, between adjacent photovoltaic cells, the busbar electrode of one of the photovoltaic cells and an electrode on a rear-surface side of the other photovoltaic cell being connected via a tab wire, wherein
the busbar electrode and the tab wire are bonded via conductive resin having light-transmission property, and
the conductive resin covers at least a part of a side face of the busbar electrode.

2. The photovoltaic module according to claim 1, wherein the conductive resin covers a side face of the busbar electrode to reach a surface of the photovoltaic cell.

3. The photovoltaic module according to claim 1, wherein the tab wire has a width smaller than a width of the busbar electrode.

4. The photovoltaic module according to claim 1, wherein the conductive resin is formed in a tape shape that is wider than the busbar electrode, and is melted by heating so as to cover at least a part of a side face of the busbar electrode.

5. The photovoltaic module according to claim 1, wherein the busbar electrode has a modified cross section.

6. A method for manufacturing a photovoltaic module comprising a plurality of photovoltaic cells, each photovoltaic cell including a busbar electrode on a surface side, between adjacent photovoltaic cells, the busbar electrode of one of the photovoltaic cells and an electrode on a rear-surface side of the other photovoltaic cell being connected via a tab wire, the method comprising the steps of:

when the busbar electrode and the tab wire are bonded,
on the busbar electrode, placing conductive resin in a tape shape that is wider than the busbar electrode and having light-transmission property, and then placing the tab wire; and
performing compression-bonding while applying heat thereto, to thereby melt the conductive resin so as to bond with the busbar electrode and the tab wire while covering at least a part of a side face of the busbar electrode by the conductive resin.

EP 2 728 626 A1

# FIG. 1

# FIG. 2

11

# FIG. 3

# FIG. 4

FIG. 5

EP 2 728 626 A1

FIG. 6

EP 2 728 626 A1

# FIG. 7

# FIG. 8

<BEFORE HEATING>                    <AFTER HEATING>

# FIG. 9

# FIG. 10

<BEFORE HEATING>                    <AFTER HEATING>

# FIG. 11

# FIG. 12

# FIG. 13

# FIG. 14

# EP 2 728 626 A1

<table>
<tr><td colspan="2" align="center">**INTERNATIONAL SEARCH REPORT**</td><td>International application No.<br>PCT/JP2012/069340</td></tr>
</table>

**A. CLASSIFICATION OF SUBJECT MATTER**
*H01L31/042*(2006.01)i

According to International Patent Classification (IPC) or to both national classification and IPC

**B. FIELDS SEARCHED**

Minimum documentation searched (classification system followed by classification symbols)
H01L31/042

Documentation searched other than minimum documentation to the extent that such documents are included in the fields searched
| | | | |
|---|---|---|---|
| Jitsuyo Shinan Koho | 1922–1996 | Jitsuyo Shinan Toroku Koho | 1996–2012 |
| Kokai Jitsuyo Shinan Koho | 1971–2012 | Toroku Jitsuyo Shinan Koho | 1994–2012 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | JP 2011-49349 A (Sanyo Electric Co., Ltd.),<br>10 March 2011 (10.03.2011),<br>entire text; fig. 4, 5<br>& EP 2472597 A          & WO 2011/024662 A1<br>& CN 102576765 A | 1,2,4<br>3,5<br>6 |
| Y | JP 2008-53681 A (Kyocera Corp.),<br>06 March 2008 (06.03.2008),<br>fig. 5<br>& US 2007/0235077 A1 | 3 |
| Y | JP 2008-135654 A (Sanyo Electric Co., Ltd.),<br>12 June 2008 (12.06.2008),<br>claim 1; fig. 4<br>& US 2008/0121266 A1      & EP 1942530 A2<br>& KR 10-2008-0048952 A   & CN 101192629 A<br>& CN 102136513 A         & TW 200834943 A | 5 |

☐ Further documents are listed in the continuation of Box C.  ☐ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>    23 October, 2012 (23.10.12) | Date of mailing of the international search report<br>    30 October, 2012 (30.10.12) |
|---|---|
| Name and mailing address of the ISA/<br>    Japanese Patent Office | Authorized officer |
| Facsimile No. | Telephone No. |

Form PCT/ISA/210 (second sheet) (July 2009)

19

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004204256 A

- JP 2005050780 A